# EUROPÄISCHE PATENTANMELDUNG

(11) **EP 1 168 022 A2**
(43) Veröffentlichungstag der Anmeldung: **02.01.2002**
(21) Anmeldenummer: 01250221.7
(22) Anmeldetag: 15.06.2001
(51) Int. Cl.: G02B 6/42

(54) **Optomodul mit durchkontaktiertem Trägersubstrat**

(30) Priorität: 28.06.2000 DE 10032796
(71) Anmelder: Infineon Technologies AG, 81669 München (DE)
(72) Erfinder: Schrödinger, Karl, 14089 Berlin (BE)
(74) Vertreter: Müller, Wolfram Hubertus, Dipl.-Phys.

(57) **Zusammenfassung**

Die Erfindung bezieht sich auf ein Optomodul mit einem Trägersubstrat (2); Verdrahtungsmitteln, die auf einer Vorderseite des Trägersubstrats (2) aufgebracht sind; Kontaktmitteln (11), die auf einer Rückseite des Trägersubstrats (2) angeordnet sind und über mindestens eine in dem Trägersubstrat ausgebildete Durchkontaktierung (12) mit einer Leitung der Verdrahtungsmittel elektrisch verbunden sind; und einem Optohalbleiter (3) zum Senden und/oder zum Empfangen von Licht, wobei der Optohalbleiter (3) mit der Leitung der Verdrahtungsmittel in elektrischem Kontakt steht und auf einer Vorderseite des Trägersubstrats (2) im Bereich einer in dem Trägersubstrat (2) ausgebildeten Durchgangsöffnung (13) so angeordnet ist, daß das Licht durch die Durchgangsöffnung (13) hindurch gesendet und/oder empfangen werden kann.

## Beschreibung

### Optomodul

Die Erfindung liegt auf dem Gebiet optischer Bauelemente, insbesondere optischer Subkomponenten, die auch als Opto-ICs bezeichnet werden.

Solche optischen Bauelemente werden benutzt, um optische Signale zu erzeugen, zu empfangen, umzuwandeln, zu verarbeiten usw. Es kann sich beispielsweise um eine PIN-Fotodiode-Vorverstärker-Kombination handeln. Es ist bekannt, die optischen Subkomponenten auf der Basis von TO46-Gehäusen zu bauen.

Aus dem Artikel von C. Schwantes: "Small Form Factor: Higher Density For Fiber Based High Speed Networking", Electronic Components and Technology Conference IEEE, 1999, Seiten 539-542, sind optische Subkomponenten bzw. Optomodule auf der Basis der Leadframe-Technologie bekannt. Die zunehmende Verbreitung und Anwendung von Optomodulen verlangt einen höheren Grad der Integrationsdichte, welcher mit diesen bekannten Techniken nicht erreicht werden kann.

Aufgabe der vorliegenden Erfindung ist es deshalb, ein Optomodul zu schaffen, welches eine höhere Integrationsdichte der Komponenten des Optomoduls ermöglicht.

Diese Aufgabe wird erfindungsgemäß durch ein Optomodul gemäß Anspruch 1 gelöst. Das Optomodul umfaßt ein Trägersubstrat; Verdrahtungsmittel, die auf einer Vorderseite des Trägersubstrats aufgebracht sind; Kontaktmittel, die auf einer Rückseite des Trägersubstrats angeordnet sind und über mindestens eine in dem Trägersubstrat ausgebildete Druchkontaktierung mit einer Leitung der Verdrahtungsmittel elektrisch verbunden sind; und ein Optohalbleiter zum Senden und/oder Empfangen von Licht, wobei der Optohalbleiter mit der Leitung der Verdrahtungsmittel in elektrischem Kontakt steht und auf einer Vorderseite des Trägersubstrats im Bereich einer in dem Trägersubstrat ausgebildeten Durchgangsöffnung so angeordnet ist, daß das Licht durch die Durchgangsöffnung hindurch gesendet und/oder empfangen werden kann.

Der Erfindung liegt der wesentliche Gedanke zugrunde, beim Aufbau und der Herstellung von Optomodulen mit einem Optohalbleiter Technologien zu nutzen, wie sie beispielsweise für integrierte Schaltungen verwendet werden. Auf diese Weise wird eine hohe Integration der Komponenten des Optomoduls möglich, da die Verdrahtung des Trägersubstrats wesentlich komplexer und flexibler als bei den bekannten Techniken, beispielsweise der Leadframe-Technologie realisiert werden kann.

Ein wesentlicher Vorteil der Erfindung gegenüber dem Stand der Technik besteht darin, daß eine verbesserte Hochfrequenztauglichkeit des Optomoduls, insbesondere des Trägersubstrats gewährleistet ist. Dieses ist die Folge der verbesserten Verdrahtungsmöglichkeiten und kurzer Anbindungen von Hochfrequenzkomponenten, beispielsweise Kondensatoren in dem Trägersubstrat.

Ein weiterer Vorteil der Erfindung besteht darin, daß Technologien und Verarbeitungsschritte genutzt werden können, für deren Ausführung umfangreiche Erfahrungen im Zusammenhang mit der Herstellung integrierter Schaltungen bestehen.

Eine zweckmäßige Weiterbildung der Erfindung sieht vor, daß der Optohalbleiter auf einer vorderseitigen Oberfläche des Trägersubstrats angeordnet ist, wodurch ein einfaches und mit geringem Aufwand ausführbares Aufbringen des Optohalbleiters ermöglicht ist.

Bei einer vorteilhaften Ausgestaltung der Erfindung ist eine Schutzschicht vorgesehen, die den Optohalbleiter wenigstens teilweise umgibt und derart auf der Vorderseite des Trägersubstrats aufgebracht ist, daß eine im wesentlichen geschlossene Schutzoberfläche gebildet ist, wodurch bei der Verwendung bzw. dem Einsatz des Optomoduls ein Schutz vor mechanischen Störeinflüssen gebildet ist.

Zweckmäßig ist bei einer Ausführungsform auf der Vorderseite des Trägersubstrats ein Bauelement angeordnet, das mit dem Optohalbleiter und der Leitung der Verdrahtungsmittel in elektrischem Kontakt steht und zumindest teilweise von der Schutzschicht umgeben ist. Hierdurch ist eine Beschaltung des Optohalbleiters zum Betreiben und Steuern desselben ermöglicht.

Vorzugsweise ist die Schutzschicht von einer Vergußmasse oder einer Spritzmasse gebildet, wodurch die Schutzschicht mit Hilfe bekannter Techniken auf einfache Art und Weise geschaffen werden kann.

Eine hinsichtlich der Verwendung moderner Chip-Herstellungstechnologien bevorzugte Ausführungsform der Erfindung sieht vor, daß der Optohalbleiter und/oder das Bauelement jeweils über eine Bondverbindung mit der Leitung der Verdrahtungsmittel verbunden sind.

Eine in Bezug auf die komplexe Verdrahtung und die verbesserte Hochfrequenztauglichkeit bevorzugte Ausgestaltung der Erfindung sieht vor, daß die Verdrahtungsmittel mindestens eine Verdrahtungsebene und eine Masseebene umfassen.

Eine zweckmäßige Weiterbildung der Erfindung sieht vor, daß das Trägersubstrat aus einem Leiterplattenmaterial gebildet ist, wodurch für die Be- und Verarbeitung des Trägersubstrats eine Vielzahl von bewährten Techniken zur Verfügung stehen.

Eine hinsichtlich der störungsfreien Funktionalität des Optomoduls zweckmäßige Ausgestaltung der Erfindung sieht vor, daß für den Optohalbleiter und/oder das Bauelement eine Schirmung ausgebildet ist, die mit Hilfe einer Schirmungsschicht gebildet ist, wobei sich die Schirmungsschicht im wesentlichen über den gesamten Bereich des Trägersubstrats erstreckt.

Zur Erhöhung der Integrationsdichte des Optomoduls kann vorgesehen sein, daß die Schirmungsschicht von dem Trägersubstrat umfaßt ist.

Eine induktivitätsarme Anbindung des Optomoduls kann bei einer zweckmäßigen Fortbildung der Erfindung dadurch gewährleistet werden, daß die Kontaktmittel Lotbälle sind.

Eine hinsichtlich der Flexibilität der Anbindung des Optomoduls bevorzugte Ausführungsform sieht vor, daß die Kontaktmittel jeweils mit Anschlußpins elektrisch verbunden sind.

Eine verbesserte Kopplung des von dem Optohalbleiter ausgesendeten Lichts bzw. des auf den Optohalbleiter zu koppelnden Lichts kann bei einer vorteilhaften Ausführungsform dadurch erreicht werden, daß in der Durchgangsöffnung ein optisches Abbildungselement angeordnet ist.

Eine hinsichtlich der Leitung des von dem Optohalbleiter ausgesendeten Lichts zu einem anderen Bauelement, beispielsweise einem Stecker mit einem Lichtwellenleiter bevorzugte Ausgestaltung der Erfindung sieht vor, daß auf einer rückseitigen Oberfläche des Trägersubstrats ein optisches Element angeordnet ist, so daß das durch die Durchgangsöffnung hindurch tretende Licht optisch geleitet werden kann.

Die mit dem beschriebenen Optomodul verbundenen Vorteile erweitern und verbessern die Anwendungsmöglichkeiten des Optomoduls dann zweckmäßig, wenn eine Verbindungsanordnung mit einem solchen Optomodul und einem Leiterplattenabschnitt gebildet ist, wobei die Kontaktmittel mit einer Verdrahtung des Leiterplattenabschnitts in elektrischem Kontakt stehen, und das Optomodul mit Hilfe der Kontaktmittel auf dem Leiterplattenabschnitt montiert ist, so daß das Licht durch eine Öffnung in dem Leiterplattenabschnitt hindurch gesendet und/oder empfangen werden kann. Auf diese Weise ist eine flexible Anbindung des Optomoduls an eine Vielzahl anderer Schaltungskomponenten bzw. Schaltungen möglich.

Eine hohe Integration einer solchen Verbindungsanordnung kann bei einer bevorzugten Fortbildung der Erfindung dadurch erreicht werden, daß in dem Leiterplattenabschnitt ein Lichtkanal ausgebildet ist, so daß Sendelicht, welches von dem Optohalbleiter durch die Durchgangsöffnung in dem Trägersubstrat hindurch gesendet wird, in den Lichtkanal eingekoppelt werden kann, und Empfangslicht aus dem Lichtkanal durch die Durchgangsöffnung in dem Trägersubstrat hindurch auf den Optohalbleiter gekoppelt werden kann.

Eine Führung des Lichts in dem Lichtkanal ist bei einer vorteilhaften Ausführungsform mit Hilfe eines in dem Lichtkanal angeordneten optischen Umlenkmittels und/oder eines optischen Abbildungsmittels ermöglicht.

Bei einer bevorzugten Weiterbildung der Erfindung kann vorgesehen sein, daß in der Öffnung des Leiterplattenabschnitts ein Abschnitt eines Flanschbauteils angeordnet ist, so daß zwischen einem stirnseitigen Oberflächenabschnitt des Flanschbauteils und einem rückseitigen Oberflächenabschnitt des Trägersubstrats eine Verbindung ausgebildet ist, wobei das Flanschbauteil einen Aufnahmeabschnitt zur wenigstens teilweisen Aufnahme eines Steckerbauteils aufweist, und wobei das Steckerbauteil in dem Aufnahmeabschnitt so angeordnet ist, daß das vom Optohalbleiter ausgesendete und/oder das vom Optohalbleiter empfangene Licht in das Steckerbauteil eingekoppelt bzw. aus dem Steckerbauteil ausgekoppelt werden kann. Hierdurch ist eine kompakte Kopplung zwischen dem Optomodul und einem zur Anbindung verschiedener Bauteile nutzbaren Flanschbauteil ermöglicht.

Eine hinsichtlich der mechanischen Belastbarkeit der Verbindungsanordnung bevorzugte Weiterbildung der Erfindung sieht vor, daß auf einer von dem Optomodul abgewandten Oberfläche des Leiterplattenabschnitts im Bereich der Öffnung des Leiterplattenabschnitts ein Flanschbauteil angeordnet ist, wobei das Flanschbauteil einen Aufnahmeabschnitt zur wenigstens teilweisen Aufnahme eines Steckerbauteils aufweist, und wobei das Steckerbauteil in dem Aufnahmeabschnitt so angeordnet ist, daß das vom Optohalbleiter ausgesendete und/oder das vom Optohalbleiter empfangene Licht in das Steckerbauteil gekoppelt bzw. aus dem Steckerbauteil ausgekoppelt werden kann.

Zur Vermeidung optischer Verluste kann bei einer zweckmäßigen Fortbildung der Erfindung vorgesehen sein, daß in dem Flanschbauteil ein optisches Abbildungselement zum Einkoppeln und/oder zum Auskoppeln des Licht in das bzw. aus dem Steckerbauteil angeordnet ist.

Die Erfindung wird im Folgenden anhand von Ausführungsbeispielen unter Bezugnahme auf eine Zeichnung näher erläutert. Hierbei zeigen:
- Figuren 1 bis 3: ein Optomodul von oben, von unten bzw. in einer Querschnittsdarstellung;
- Figur 4: einen vergrößerten Teilabschnitt des Optomoduls nach Figur 3;
- Figur 5: eine Verbindungsanordnung mit einem Optomodul nach Figur 3 und einem
Leiterplattenabschnitt, wobei die Verbindungsanordnung an ein Flanschbauteil gekoppelt ist;
- Figur 6: eine vergrößerte Darstellung der Verbindungsanordnung nach Figur 5;
- Figur 7: die Anordnung eines Optomoduls nach Figur 3 auf einem Flanschbauteil, wobei das Optomodul teilweise von einer Schirmung umfaßt ist;
- Figur 8: eine Anordnung mit einem Leiterplattenabschnitt und zwei hierauf angeordneten Optomodulen nach Figur 3; und
- Figuren 9 - 11: eine Ausführungsform eines Optomoduls mit Anschlußpins in Draufsicht, in Vorderansicht und in Seitenansicht.

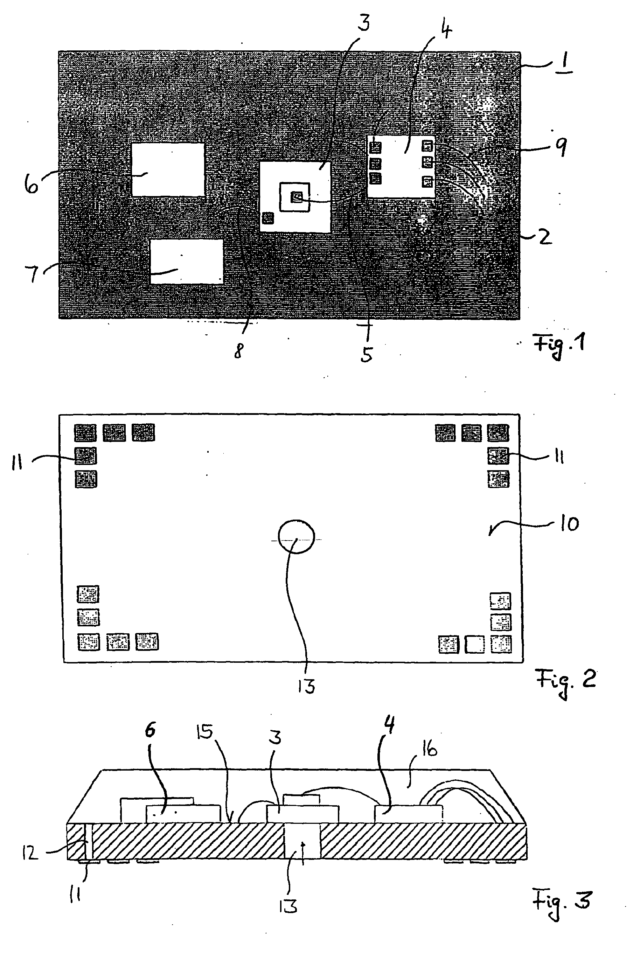

In Figur 1 ist ein Optomodul 1 in Draufsicht dargestellt. Auf einem Trägersubstrat 2 sind ein Optohalbleiter 3 ein integrierter Schaltkreis 4, welcher über eine Bondverbindung 5 mit dem Optohalbleiter 3 in elektrischem Kontakt steht, sowie weitere Bauteile, beispielsweise Kondensatoren 6, 7 angeordnet. Der Optohalbleiter 3 und der integrierte Schaltkreis 4 sind jeweils über Bondverbindungen 8, 9 mit Verdrahtungen (nicht dargestellt) verbunden, die auf dem Trägersubstrat 2, vorzugsweise in Verdrahtungsebenen (nicht dargestellt) ausgebildet sind. Derartige Bondverbindungen können selbstverständlich auch für die weiteren Bauelemente 6, 7 vorgesehen sein. Die Verdrahtungsebenen ermöglichen hierbei eine komplexe und flexibel gestaltbare Ausführung der elektrischen Verbindungen zwischen dem Optohalbleiter 3, dem integrierten Schaltkreis 4 und den weiteren Bauelementen 6, 7. Auf diese Weise können Optomodule mit komplizierten Verdrahtungswegen und Schaltungsanordnungen hergestellt werden. Vorzugsweise sind ein oder mehrere Masseebenen vorgesehen.

Als Technologien zur Herstellung des Optomoduls 1 können die "Chip Size Package"- oder die "Ball Grid Array"-Technologie genutzt werden. Die Anwendung dieser Technologien in Verbindung mit dem den Optohalbleiter 3 umfassenden Optomodul 1 ermöglicht eine hohe Integrationsdichte der einzelnen Komponenten des Optomoduls 1.

Figur 2 zeigt das Optomodul 1 von unten. Auf der unteren Oberfläche 10 des Optomodul 1 sind Lötpads 11 angeordnet. Die Lötpads 11 bilden Kontaktmittel zum Anbinden des Optomoduls 1 an äußere Schaltungskomponenten. Mit Hilfe der Lötpads 11 kann das Optomodul beispielsweise auf eine Leiterplatte aufgelötet werden.

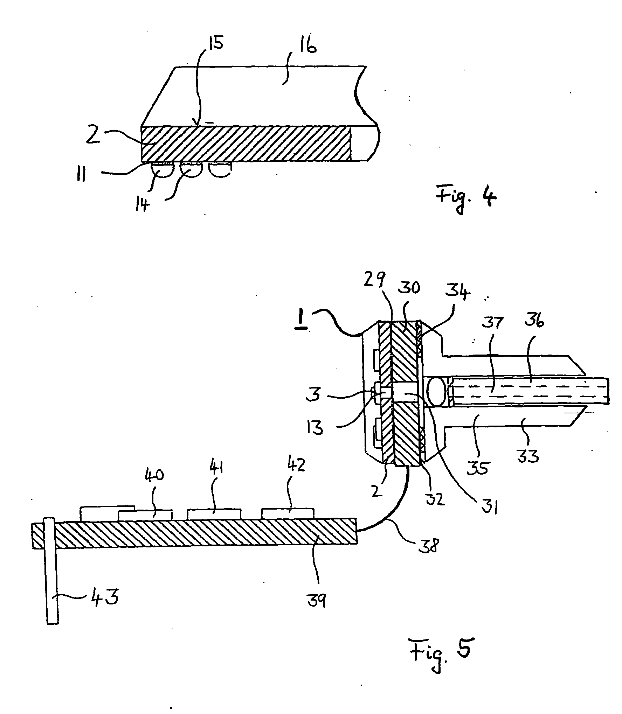

Figur 3 zeigt eine Querschnittsdarstellung des Optomoduls 1. Gemäß Figur 3 sind die Lötpads 11 mit Durchkontaktierungen 12 verbunden, die in dem Trägersubstrat 2 ausgebildet sind. Auf diese Weise wird zwischen den Lötpads 11 und der Verdrahtungsebene (nicht dargestellt) ein elektrischer Kontakt hergestellt, so daß der Optohalbleiter 3, der integrierte Schaltkreis 4 sowie die weiteren Bauelemente 6, 7 über die Lötpads 11, die Durchkontaktierung 12 und die Verdrahtungsebene mit externen Schaltungskomponenten verbunden werden können.

Das Trägersubstrat 2 weist in einem Bereich des Optohalbleiters 3 eine Durchgangsöffnung 13 auf (vgl. Fig. 2). Durch die Durchgangsöffnung 13 hindurch gelangt Licht, das von dem Optohalbleiter 3 ausgesendet wird, und/oder Licht, das auf den Optohalbleiter 3 gekoppelt werden soll. Es kann vorgesehen sein, in der Durchgangsöffnung 13 ein optisches Abbildungselement (nicht dargestellt) anzuordnen, um das Licht umzulenken und/oder auf den Optohalbleiter zu fokussieren.

Figur 4 zeigt eine vergrößerte Darstellung eines Abschnitts des Optomoduls 1 nach den Figuren 1 bis 3. Auf den Lötpads 11 ist jeweils ein Lotball 14 angeordnet. Die Verwendung der Lotbälle 14 ermöglicht eine induktivitätsarme Anbindung des Optomoduls 1 an äußere Schaltungskomponenten. Die Lotbälle 14 weisen insbesondere eine geringere Induktivität als Anschlußpins auf, wie sie aus der Leadframe-Technologie bekannt sind.

Gemäß den Figuren 3 und 4 ist auf einer oberen Oberfläche 15 des Trägersubstrats 2 eine Masse 16 aufgebracht, die den Optohalbleiter 3, den integrierten Schaltkreis 4, die weiteren Bauelemente 6, 7 sowie die Bondverbindungen 5, 8 bzw. 9 einhüllt. Die Masse 16 kann eine Vergußmasse oder eine Spritzmasse sein und dient dem Schutz der elektrischen Komponenten des Optomoduls 1. Die Masse 16 kann unter Verwendung bekannter Herstellungstechniken aufgegossen bzw. aufgespritzt werden, wie sie aus dem Bereich der Herstellung integrierter Schaltkreise bekannt sind. Mit Hilfe der Masse 16 ist ein mechanischer Schutz der elektrischen Komponenten des Optomoduls 1 geschaffen.

Zur Wärmeableitung können Kühlkörper, vorzugsweise Kühlbleche von der Masse 16 umgossen oder umspritzt sein.

Das Optomodul 1 gemäß den Figuren 1 bis 3 kann nach der Herstellung derart weiterverarbeitet werden, daß es auf einem Leiterplattenabschnitt 30 aufgelötet wird, wie dies in Figur 5 beispielhaft dargestellt ist. Zwischen dem Leiterplattenabschnitt 30 und dem Optomodul 1 ist eine Lötverbindung 29 ausgebildet. Das Optomodul 1 ist hierbei auf dem Leiterplattenabschnitt 30 positioniert, so daß die Durchgangsöffnung 13 in dem Trägersubstrat 2 relativ zu einer in dem Leiterplattenabschnitt 30 ausgebildeten Öffnung 31 angeordnet ist, derart, daß das Licht, welches von dem Optohalbleiter 3 ausgesendet wird, durch die Durchgangsöffnung 13 in dem Trägersubstrat 2 und die Öffnung 31 in dem Leiterplattenabschnitt 30 hindurch gelangen kann.

Auf einer von dem Optomodul 1 abgewandten Oberfläche 32 des Leiterplattenabschnitts 30 ist ein Flanschbauteil 33 mit Hilfe einer Klebeverbindung 34 befestigt. In einem Aufnahmeabschnitt 35 des Flanschbauteils 33 ist ein Steckerstift 36 angeordnet. Der Steckerstift 36 umfaßt einen Lichtwellenleiter 37, in den das von dem Optohalbleiter 3 ausgesendete Licht eingekoppelt wird. Selbstverständlich kann auf den Optohalbleiter 3 auch Licht gekoppelt werden, welches mit Hilfe des Lichtwellenleiters 37 übertragen wird.

Der Leiterplattenabschnitt 30 ist über einen Flexleiterabschnitt 38 mit einer Modulleiterplatte 39 verbunden. Auf der Modulleiterplatte 39 sind mehrere externe Bauelemente 40, 41, 42 montiert. Der Optohalbleiter 3, welcher über die Lötverbindung 29 mit der Verdrahtung des Leiterplattenabschnitts 30 in Verbindung steht, kann auf diese Weise unter Einbeziehung des Flexleiterabschnitts 38 und der Modulleiterplatte 39 an die externen Bauelemente 40, 41 bzw. 42 gekoppelt werden. An der Modulleiterplatte 39 ist weiterhin ein Anschlußstift 43 ausgebildet, welcher es ermöglicht, die Modulleiterplatte 39 auf einen Sockel zu stecken.

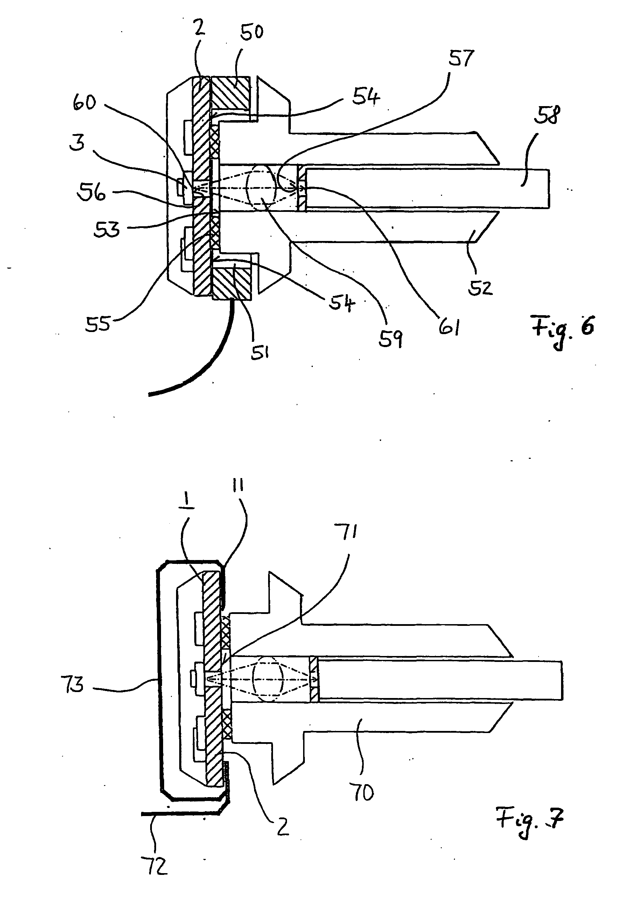

Zur Vermeidung von optischen Verlusten beim Einkoppeln des Lichts in den Lichtwellenleiter 37 bzw. beim Koppeln von Licht auf den Optohalbleiter 3 ist in dem Flanschbauteil 36 ein optisches Abbildungselement 44 angeordnet. Es kann sich hierbei um eine Abbildungslinse handeln (vgl. Figur 6).

Figur 6 zeigt eine Verbindungsanordnung, bei der in einem Leiterplattenabschnitt 50 eine Öffnung 51 derart ausgebildet ist, daß in die Öffnung 51 ein Flanschbauteil 52 teilweise eingeführt werden kann, so daß zwischen einer stirnseitigen Oberfläche 53 des Flanschbauteils 52 und einer unteren Oberfläche 54 des Trägersubstrats 2 eine Klebeverbindung 55 ausgebildet werden kann. Der Unterschied zu der Ausführungsform nach Figur 3 besteht somit darin, daß eine direkte Verbindung zwischen dem Flanschbauteil 52 und dem Trägersubstrat 2 gebildet ist.

In Figur 6 ist zwischen einer Sende-/Empfangsfläche 56 des Optohalbleiters 3 und einer Stirnfläche 57 eines Lichtwellenleiters 58 ein optisches Linsenelement 59 angeordnet, um optische Verluste zu vermeiden. Das optische Linsenelement ist hierbei dahingehend optimiert, daß Fokussierungspunkte 60, 61 auf der Sende-/Empfangsoberfläche 56 des Optohalbleiters 3 bzw. auf der Stirnfläche 57 des Lichtwellenleiters 58 erzeugt werden.

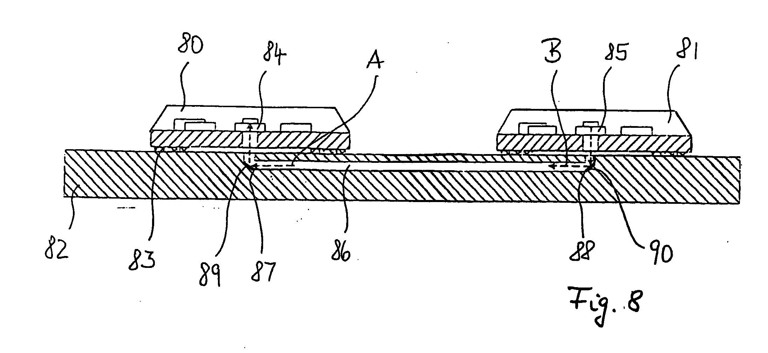

In Figur 7 ist eine Ausführungsform mit einem Optomodul 1 und einem Flanschbauteil 70 dargestellt, wobei, wie bei der Ausführungsform in Figur 4, eine direkte Befestigung des Flanschbauteils 70 auf einer unteren Oberfläche 71 des Trägersubstrats 2 gebildet ist. Ein Unterschied zur Ausführungsform nach Figur 4 besteht darin, daß das Optomodul 1 nicht mit Hilfe der Lötpads 11 auf einem Leiterplattenabschnitt montiert ist, sondern die Lötpads 11 mit (Leadframe-) Anschlußpins 72 verbunden sind. Bei dieser Ausführungsform kann mit Hilfe des Leadframe-Materials auch ein Schirmblech 73 ausgeformt werden, welches im gleichen Arbeitsgang wie die Anschlußpins 72 aufgelötet wird. Das Schirmblech 73 bildet eine elektromagnetische Schirmung für das Optomodul 1.

Figur 8 zeigt eine Anwendung, bei der ein erstes und ein zweites Optomodul 80, 81, welche dem Optomodul 1 nach den Figuren 1a-1c entsprechend ausgebildet sind, auf einer Systemleiterplatte 82 mit Hilfe von Lötverbindungen 83 montiert sind. Zwischen jeweiligen Optohalbleitern 84, 85 des ersten und des zweiten Optomoduls 80, 81 können über einen in der Systemleiterplatte 82 ausgebildeten Lichtkanal 86 Lichtsignale ausgetauscht werden. Dieses ist in Figur 6 mit Hilfe von Pfeilen A, B angedeutet. Die Lichtsignale werden hierbei in Eckbereichen 87, 88 des Lichtkanals 86 mit Hilfe jeweiliger Umlenkspiegel 89 bzw. 90 umgelenkt.

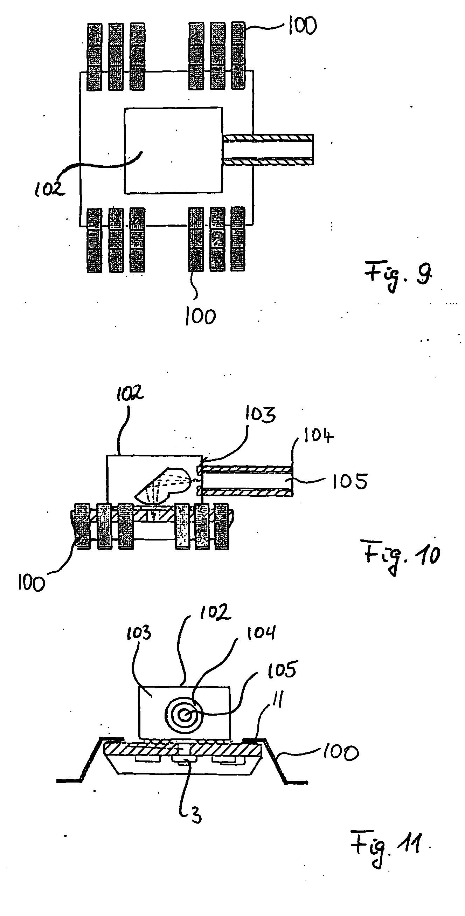

In den Figuren 9 bis 11 ist ein Optomodul 1 nach den Figuren 1 - 3 dargestellt, bei dem die Lötpads 11 mit (Leadframe-) Anschlußpins 100 verbunden sind. Im Bereich der Durchgangsöffnung 13 des Trägersubstrats 2 ist auf einer unteren Oberfläche 101 des Trägersubstrats 2 ein optisches Bauelement 102 zum Leiten des von dem Optohalbleiter 3 ausgesandten Lichts angeordnet. Das optische Bauelement 102 ist hierbei vorzugsweise aufgeklebt.

Gemäß Figur 11 kann mit Hilfe des optischen Bauelements 102 eine Umlenkung des ausgesendeten Lichts erfolgen, wobei eine seitliche Oberfläche 103 des optischen Bauelements 102 eine Anschlagfläche für einen Steckerstift 104 mit einem Lichtwellenleiter 105 bildet. Das aus dem Optohalbleiter 3 austretende Licht kann auf diese Weise direkt in den Lichtwellenleiter 105 des Steckerstifts 104 eingekoppelt werden. Selbstverständlich ist in gleicher Weise das Koppeln von Licht aus dem Lichtwellenleiter 105 auf den Optohalbleiter 3 möglich.

## Patentansprüche

1. Optomodul (1) mit:
- einem Trägersubstrat (2);
- Verdrahtungsmitteln, die auf einer Vorderseite des Trägersubstrats (2) aufgebracht sind;
- Kontaktmitteln (11), die auf einer Rückseite des Trägersubstrats (2) angeordnet sind und über mindestens eine in dem Trägersubstrat ausgebildete Durchkontaktierung (12) mit einer Leitung der Verdrahtungsmittel elektrisch verbunden sind; und
- einem Optohalbleiter (3) zum Senden und/oder zum Empfangen von Licht, wobei der Optohalbleiter (3) mit der Leitung der Verdrahtungsmittel in elektrischem Kontakt steht und auf einer Vorderseite des Trägersubstrats (2) im Bereich einer in dem Trägersubstrat (2) ausgebildeten Durchgangsöffnung (13) so angeordnet ist, daß das Licht durch die Durchgangsöffnung (13) hindurch gesendet und/oder empfangen werden kann.

2. Optomodul (1) nach Anspruch 1,
**dadurch gekennzeichnet, daß** der Optohalbleiter (3) auf einer vorderseitigen Oberfläche (15) des Trägersubstrats (2) angeordnet ist.

3. Optomodul (1) nach Anspruch 1 oder 2,
**gekennzeichnet durch**
eine Schutzschicht, die den Optohalbleiter (3) wenigstens teilweise umgibt und derart auf der Vorderseite des Trägersubstrats (2) aufgebracht ist, daß eine im wesentlichen geschlossene Schutzoberfläche gebildet ist.

4. Optomodul (1) nach Anspruch 3,
**dadurch gekennzeichnet,**
**daß** auf der Vorderseite des Trägersubstrats (2) ein Bauelement (4, 6 bzw. 7) angeordnet ist, das mit dem Optohalbleiter (3) und der Leitung der Verdrahtungsmittel in elektrischem Kontakt steht und zumindest teilweise von der Schutzschicht (16) umgeben ist.

5. Optomodul (1) nach Anspruch 3 oder 4,
**dadurch gekennzeichnet,**
**daß** die Schutzschicht (16) von einer Vergußmasse gebildet ist.

6. Optomodul (1) nach Anspruch 3 oder 4,
**dadurch gekennzeichnet,**
**daß** die Schutzschicht (16) von einer Spritzmasse gebildet ist.

7. Optomodul (1) nach einem der vorangehenden Ansprüche,
**dadurch gekennzeichnet,**
**daß** der Optohalbleiter (3) und/oder das Bauelement (4, 6 bzw. 7) jeweils über mindestens eine Bondverbindung ( 8 bzw. 9) mit der Leitung der Verdrahtungsmittel verbunden sind.

8. Optomodul (1) nach einem der vorangehenden Ansprüche,
**dadurch gekennzeichnet,**
**daß** die Verdrahtungsmittel mindestens eine Verdrahtungsebene und eine Masseebene umfassen.

9. Optomodul (1) nach einem der vorangehenden Ansprüche,
**dadurch gekennzeichnet,**
**daß** das Trägersubstrat (2) aus einem Leiterplattenmaterial gebildet ist.

10. Optomodul (1) nach einem der vorangehenden Ansprüche,
**gekennzeichnet durch** eine
elektromagnetische Schirmung für den Optohalbleiter (3) und/oder das Bauelement (4, 6 bzw. 7), die mit Hilfe einer Schirmungsschicht gebildet ist, wobei sich die Schirmungsschicht im wesentlichen über den gesamten Bereich des Trägersubstrats (2) erstreckt.

11. Optomodul (1) nach Anspruch 10,
**dadurch gekennzeichnet,**
**daß** die Schirmungsschicht von dem Trägersubstrat (2) umfaßt ist.

12. Optomodul (1) nach einem der vorangehenden Ansprüche,
**dadurch gekennzeichnet,**
**daß** die Kontaktmittel Lotbälle (14) sind.

13. Optomodul (1) nach einem der vorangehenden Ansprüche,
**dadurch gekennzeichnet,**
**daß** die Kontaktmittel jeweils mit Anschlußpins (100) mechanisch und elektrisch verbunden sind.

14. Optomodul (1) nach einem der vorangehenden Ansprüche,
**dadurch gekennzeichnet,**
**daß** in der Durchgangsöffnung (13) ein optisches Abbildungselement angeordnet ist.

15. Optomodul (1) nach einem der vorangehenden Ansprüche,
**dadurch gekennzeichnet,**
**daß** auf einer rückseitigen Oberfläche des Trägersubstrats (3) ein optisches Element (102) angeordnet ist, so daß das durch die Durchgangsöffnung (13) hindurch tretende Licht optisch geleitet werden kann.

16. Verbindungsanordnung mit einem Optomodul (1) nach einem der Ansprüche 1 bis 14 und einem Leiterplattenabschnitt,
**dadurch gekennzeichnet,**
**daß** die Kontaktmittel mit einer Verdrahtung des Leiterplattenabschnitts in elektrischem Kontakt stehen, und daß das Optomodul (1) mit Hilfe der Kontaktmittel auf dem Leiterplattenabschnitt (30; 50; 82) montiert ist, so daß das Licht durch eine Öffnung (31 bzw. 51) in dem Leiterplattenabschnitt (30; 50; 82) hindurch gesendet und/oder empfangen werden kann.

17. Verbindungsanordnung nach Anspruch 16,
**dadurch gekennzeichnet,**
**daß** in dem Leiterplattenabschnitt (82) ein Lichtkanal (86) ausgebildet ist, so daß Sendelicht, welches von dem Optohalbleiter (3) durch die Durchgangsöffnung (13) in dem Trägersubstrat (2) hindurch gesendet wird, in den Lichtkanal (86) eingekoppelt werden kann, und Empfangslicht aus dem Lichtkanal (86) durch die Durchgangsöffnung (13) in dem Trägersubstrat (2) hindurch auf den Optohalbleiter (3) gekoppelt werden kann.

18. Verbindungsanordnung nach Anspruch 17,
**dadurch gekennzeichnet,**
**daß** in dem Lichtkanal ein optisches Umlenkmittel (89; 90) und/oder eine optisches Abbildungsmittel angeordnet sind.

19. Verbindungsanordnung nach Anspruch 16,
**dadurch gekennzeichnet,**
**daß** in der Öffnung (51) des Leiterplattenabschnitts (50) ein Abschnitt eines Flanschbauteils (52) angeordnet ist, so daß zwischen einem stirnseitigen Oberflächenabschnitt (53) des Flanschbauteils (52) und einem rückseitigen Oberflächenabschnitt (54) des Trägersubstrats (2) eine Verbindung (55) ausgebildet ist, wobei das Flanschbauteil (52) einen Aufnahmeabschnitt zur wenigstens teilweisen Aufnahme eines Steckerbauteils (58) aufweist, und wobei das Steckerbauteil (58) in dem Aufnahmeabschnitt so angeordnet ist, daß das vom Optohalbleiter (3) ausgesendete und/oder das vom Optohalbleiter (3) empfangene Licht in das Steckerbauteil (58) eingekoppelt bzw. aus dem Steckerbauteil (58) ausgekoppelt werden kann.

20. Verbindungsanordnung nach Anspruch 16,
**dadurch gekennzeichnet,**
**daß** auf einer von dem Optomodul (1) abgewandten Oberfläche (32) des Leiterplattenabschnitts (30), im Bereich der Öffnung (31) des Leiterplattenabschnitts (30) ein Flanschbauteil (33) angeordnet ist, wobei das Flanschbauteil (33) einen Aufnahmeabschnitt (35) zur wenigstens teilweisen Aufnahme eines Steckerbauteils (36) aufweist, und wobei das Steckerbauteil (36) in dem Aufnahmeabschnitt (35) so angeordnet ist, daß das vom Optohalbleiter (3) ausgesendete und/oder das vom Optohalbleiter (3) empfangene Licht in das Steckerbauteil (36) eingekoppelt bzw. aus dem Steckerbauteil (36) ausgekoppelt werden kann.

21. Verbindungsanordnung nach Anspruch 19 oder 20,
**dadurch gekennzeichnet,**
**daß** in dem Flanschbauteil (33; 52) ein optisches Abbildungselement (44; 59) zum Einkoppeln und/oder zum Auskoppeln des Lichts in das bzw. aus dem Steckerbauteil (33; 52) angeordnet ist.
